# EUROPÄISCHE PATENTSCHRIFT

(11) **EP 2 016 451 B1**
(45) Veröffentlichungstag und Bekanntmachung des Hinweises auf die Patenterteilung: **10.08.2016**
(21) Anmeldenummer: 07718431.5
(22) Anmeldetag: 08.05.2007
(51) Int. Cl.: G02B 6/42, G02B 6/138

(54) **LEITERPLATTENELEMENT UND METHODE DER HERSTELLUNG**
PRINTED CIRCUIT BOARD ELEMENT
ÉLÉMENT CARTE DE CIRCUITS IMPRIMÉS

(30) Priorität: 08.05.2006 AT 7912006
(43) Veröffentlichungstag der Anmeldung: 21.01.2009
(73) Patentinhaber: AT & S Austria Technologie & Systemtechnik Aktiengesellschaft, 8700 Leoben-Hinterberg (AT)
(72) Erfinder: RIESTER, Markus, A-8054 Seiersberg (AT); LANGER, Gregor, 9061 Wölfnitz (AT)
(74) Vertreter: Sonn & Partner Patentanwälte
(86) Internationale Anmeldenummer: PCT/AT2007/000217
(87) Internationale Veröffentlichungsnummer: WO 2007/128022

(56) Entgegenhaltungen:
- EP-A- 0 273 703
- EP-A- 1 387 193
- EP-A- 1 701 188
- EP-A- 1 715 368
- EP-A1- 0 911 658
- EP-A2- 1 312 948
- WO-A-2005/064831
- DE-C1- 19 616 015
- GB-A- 2 155 194
- JP-A- 2000 249 873
- US-A- 4 666 236
- US-A1- 2002 039 464
- US-B1- 6 845 184

## Beschreibung

Die Erfindung betrifft ein Leiterplattenelement gemäß dem Oberbegriff von Anspruch 1.

Weiters bezieht sich die Erfindung auf ein Verfahren zur Herstellung eines solchen Leiterplattenelements.

Aus der WO 01/16630 A1 ist ein Multilayer-Leiterplattenelement bekannt, bei dem optoelektronische Bauelemente, insbesondere VCSEL-Bauelemente, in Verbindung mit einem Licht-Wellenleiter vorgesehen sind. Der Licht-Wellenleiter ist hier durch eine flächige optische Wellenleiter-Schicht zwischen Pufferschichten gebildet, innerhalb von der der vom VCSEL-Bauelement abgegebene Laserstrahl mit Hilfe eines Umlenkspiegels ausgerichtet werden muss. Notwendig ist hierfür, dass ein enger, gebündelter Laserstrahl vom VCSEL-Bauelement erzeugt und vom Umlenkspiegel weitergeleitet wird. Das jeweilige VCSEL-Bauelement wird in einer der Pufferschichten benachbart der optischen Wellenleiter-Schicht eingebaut, wogegen der plane, schräg gestellte Umlenkspiegel in der Wellenleiter-Schicht vorgesehen wird, um den emittierten Laserstrahl um 90° in die Wellenleiter-Schicht umzulenken. Bei dieser Bauweise ist die Ausrichtung des VCSEL-Bauelements und des zugehörigen Umlenkspiegels kritisch.

Aus der EP 911 658 A1 und EP 1 312 948 A2 ist es bekannt, Wellenleiterstrukturen mit Umlenkspiegeln auf einem Substrat vorzusehen, wobei die Umlenkspiegel an vorgegebenen Auskoppelstellen in einer Wellenleiterstruktur angebracht sind. Im Einzelnen wird dabei der jeweilige Umlenkspiegel in eine flüssige, lichtempfindliche Schicht - entweder im Nachhinein oder vor Anbringung dieser Schicht - eingebettet, und anschließend wird die Wellenleiterstruktur durch Belichten hergestellt, wobei das Material der lichtempfindlichen Schicht im belichteten Bereich aushärtet. Das nicht ausgehärtete Material der lichtempfindlichen Schicht wird dann entfernt. Anschließend wird eine Deckschicht auf dieser Struktur abgeschieden, die aus einem Polymer mit einem vom Wellenleiter verschiedenen Brechungsindex besteht. Die so erhaltene Struktur ist somit ähnlich jener gemäß der vorstehend beschriebenen WO 01/16630 A1, mit den Problemen der kritischen Ausrichtung der Bauelemente und der engen Strahlführung in der Wellenleiterstruktur. Insbesondere ist von Nachteil, dass die z-Position (Höhenposition) des Wellenleiters weder eingestellt noch während des Schreibprozesses verändert werden kann. Dies hat den Nachteil einer eingeschränkten Positionierung des Wellenleiters zum jeweiligen Bauteil zur Folge. Die Positionierung der z-Koordinate des Wellenleiters ist nämlich beispielsweise unumgänglich, wenn der Wellenleiter relativ zu asphärischen Umlenkspiegeln positioniert werden soll. Sollten kompakte Wellenleiterstrukturen mit dreidimensionalem Verlauf gewünscht sein, so sind sie bei der bekannten Technik nur mit äußerst komplizierten Mehrschrittprozessen möglich. Ferner werden bei diesem Stand der Technik vorgegebene Auskoppelstellen benötigt, wobei auf der Deckschicht Linsen in diesen Auskoppelstellen vorgesehen werden; relativ zu diesen Linsen müssen die Umlenkspiegel ganz exakt positioniert werden.

Aus der WO 03/005094 A1 ist weiters eine Technik zur Kopplung an in Leiterplatten eingebettete Licht-Wellenleiter bekannt, wobei die Licht-Wellenleiter durch einen Prägeprozess in einer optischen Schicht erzeugt werden und Licht durch abgeschrägte und verspiegelte Enden der Licht-Wellenleiter ausgekoppelt wird. Für die Positionierung werden mit dem Prägeprozess mechanische Führungsmarken erzeugt, die als Führungslöcher für MT-Stifte dienen können. Diese Herstellungsart ist relativ kompliziert, wobei in einer transparenten Trägerfolie zunächst die Kanäle für die Wellenleiter erzeugt und für die Spiegel Abschrägungen an den Enden der Kanäle vorgesehen werden. Danach werden die Kanäle ausgefüllt, um so die Wellenleiter zu bilden.

In der EP 1 715 368 A1 ist ein Bauteil zur optischen Kopplung geoffenbart, bei dem ein Koppelelement und eine Wellenleiterstruktur auf einem gemeinsamen Substrat aufgebracht sind. Das Koppelelement enthält einen gekrümmten Umlenkspiegel. Für die Wellenleiterstruktur ist ein Mehrschichtaufbau, mit zumindest zwei Materialschichten, nämlich einer Unterlags- bzw. Deckschicht und zusätzlich einer Kernschicht, vorgesehen. Die Wellenleiterstruktur wird durch Belichtung erzeugt.

Es ist andererseits bereits bekannt, in einem organischen oder anorganischen optischen, photopolymerisierbaren Material eine optische Wellenleiterstruktur mit Hilfe von Zwei- oder Mehrphotonen-Absorptionsprozessen zu erzeugen, wobei das optische Material lokal beim Bestrahlen mit Photonen derart umgewandelt wird, dass es einen größeren Brechungsindex aufweist, verglichen mit dem nicht strukturierten ursprünglichen optischen Material. Dies ist im Zusammenhang mit Optokoppler-Bauelementen beispielsweise aus WO 01/96915 A2, WO 01/96917 A2 und US 4 666 236 A bekannt. Eine vergleichbare Wellenleiter-Strukturierung in einer optischen, photopolymerisierbaren Schicht ist im Zusammenhang mit einem Leiterplattenelement aus der WO 2005/064381 A1 bekannt, wobei die darin beschriebene Technik den Ausgangspunkt für die vorliegende Erfindung darstellt.

Es ist nun Aufgabe der Erfindung, eine Technik bei Leiterplattenelementen vorzuschlagen, mit der es auf einfache Weise möglich wird, Licht aus der Ebene einer optischen Lage in einem optischen Leiterplattenelement zwecks Auskopplung umzulenken oder aber das Licht in die Ebene dieser optischen Lage einzukoppeln, wobei die Strukturierung des Wellenleiters weiterhin unproblematisch und insbesondere keine mechanische Nachbearbeitung des Wellenleiters erforderlich sein soll. Weiters sollen die optischen Komponenten nicht nachträglich eingesetzt und ausgerichtet werden müssen, und es soll somit eine einfache, äußerst präzise Montage der optischen und optoelektronischen Bauelemente in einem Leiterplattenelement mit integriertem optischen System ermöglicht werden.

Zur Lösung dieser Aufgabe sieht die Erfindung ein Leiterplattenelement wie in Anspruch 1 gekennzeichnet sowie ein Verfahren wie in Anspruch 16 definiert vor. Vorteilhafte Ausführungsformen und Weiterbildungen sind in den abhängigen Ansprüchen angegeben.

Mit der erfindungsgemäßen Technik wird ein einfach, nichtsdestoweniger sehr präzise herzustellendes Leiterplattenelement ermöglicht, bei dem ein Umlenkspiegel zwecks Einkoppeln von Licht in den Wellenleiter oder Auskoppeln von Licht aus dem Wellenleiter in das optische, schichtförmige Material eingebettet ist. Bei der Herstellung eines solchen Leiterplattenelements ist keine mechanische Nachbearbeitung des Wellenleiters erforderlich, und die optischen Komponenten, insbesondere auch der Umlenkspiegel, können im Vorhinein auf dem Substrat befestigt werden, bevor das optische Material in Schichtform aufgebracht und der Wellenleiter strukturiert wird. Insofern erübrigt sich auch eine mechanische Nachbearbeitung des Leiterplattenelements, wie etwa zwecks Herstellung von Bohrungen für eine senkrechte Licht-Auskopplung. Von besonderem Vorteil ist es auch, dass bei der Strukturierung des Wellenleiters am Umlenkspiegel (und/oder an einem Träger des Umlenkspiegels) vorhandene Markierungen für die Ausrichtung des den Wellenleiter "einschreibenden" Laserstrahls verwendet werden können. Auch ist es problemlos möglich, einen Lichtkanal senkrecht nach oben zur Oberfläche des Leiterplattenelements für das Auskoppeln oder aber Einkoppeln von Licht anzubringen. Besonders günstig ist hierbei auch die mögliche Positionierung des Wellenleiters in z-Richtung, die gerade im Fall der Vormontage von Umlenkspiegeln besondere Vorteile erbringt. Die beim Erfindungsgegenstand gegebene Kombination von Zwei- oder Mehrphotonen-Absorptionsverfahren und vorgefertigtem Umlenkspiegel auf dem Substrat erbringt in der Folge die vorteilhafte Möglichkeit, die z-Position, also Höhe, des Licht-Wellenleiters beim Photonen-Absorptionsprozess festzulegen, wobei überdies auch ein Wellenleiter vom jeweiligen Umlenkspiegel senkrecht nach oben, zum Ein- oder Auskoppeln von Licht, eingeschrieben werden kann, was beim Stand der Technik nicht möglich ist. Vor allem ist keine extrem genaue Positionierung des Umlenkspiegels notwendig, da über die Marken eine Positionssteuerung des Laserstrahls beim Einschreiben des Wellenleiters in der richtigen Position möglich ist. Auch können Linsen erst nachträglich im optischen Material hergestellt werden, wobei Positionsabweichungen des Spiegels noch ausgeglichen werden können.

Bei der erfindungsgemäßen Technik zur Wellenleiter-Strukturierung wird der an sich bekannte Photonen-Prozess (z.B. Two Photon Absorption - TPA, Zwei-Photonen-Absorption) angewandt, bei dem eine chemische Reaktion (z.B. Polymerisation) durch gleichzeitige Absorption von zwei oder mehr Photonen aktiviert wird. Von Vorteil ist dabei, dass durch die Transparenz des optischen Materials für die Anregungswellenlänge alle Punkte im Volumen erreicht und somit problemlos dreidimensionale Strukturen in das Volumen eingeschrieben werden können, wobei weiters sehr kleine Fokusbereiche und somit sehr kleine Strukturdimensionen erzielt werden können. Überdies ist der Zwei- oder Mehrphotonen-Prozess (nachstehend auch kurz: Photonen-Prozess) ein einfacher Einschritt-Strukturierungsprozess.

Im Einzelnen kann bei der Strukturierung der Licht-Wellenleiter innerhalb der optischen Schicht mit Vorteil derart wie in der WO 2005/064381 A1 beschrieben vorgegangen werden, wobei die bereits in der optischen Schicht eingebetteten Bauelemente mit Hilfe einer Kamera oder dgl. optischen Visionseinheit, mit einem Mess-Lichtstrahl, anvisiert und hinsichtlich der Position erfasst werden; über diese Visionseinheit wird sodann eine Bestrahlungseinheit mit einem Linsensystem angesteuert, um so einerseits den Fokusbereich des abgegebenen Photonenstrahls, insbesondere Laserstrahls, in der Ebene des Leiterplattenelements, d.h. in der x/y-Ebene, zu bewegen und andererseits auch in der Tiefe innerhalb der optischen Schicht, also in der z-Richtung, einzustellen. Somit kann, mit dem jeweiligen Bauelement als Bezugselement, der Licht-Wellenleiter innerhalb der optischen Schicht in der gewünschten Weise strukturiert werden, etwa als einfache geradlinige Licht-Wellenleiter-Verbindung oder aber als Wellenleiterstruktur mit Krümmungen, mit Verzweigungen oder dgl. Strukturen, insbesondere auch als dreidimensionale Struktur. Die Querschnitts-Abmessungen des so strukturierten Licht-Wellenleiters können beispielsweise in der Größenordnung von einigen Mikrometern liegen, wobei der Querschnitt eines solchen strukturierten Licht-Wellenleiters kreisförmig, aber auch elliptisch oder rechteckig sein kann; die genaue Form kann durch den Photonenstrahl und dessen Fokus-Steuerung bestimmt werden.

Von besonderem Vorteil ist bei der erfindungsgemäßen Technik, dass der ebenfalls im optischen Material eingebettete Umlenkspiegel (oder ein Träger des Spiegels) Positions-Marken für die Laserstrahl-Steuerung bei der Strukturierung des Licht-Wellenleiters aufweist, um so eine präzise Führung des Laserstrahls in der X/Y-Ebene zu erzielen; vor allem weist der Umlenkspiegel (oder sein Träger) auch ein (gegebenenfalls schräg) nach oben gewandtes reflektives Feld zur Bestimmung der Höhenlage bei der Strukturierung des Licht-Wellenleiters auf. Der Umlenkspiegel wird bevorzugt auf dem selben Substrat, auf dem auch das optoelektronische Bauelement angebracht wird, angebracht, insbesondere aufgeklebt. Dabei können die Umlenkspiegel im selben Arbeitsschritt wie die optisch aktiven Komponenten, d.h. optoelektronischen Bauelemente, wie z.B. VCSEL-Bauelemente und/oder Photodioden, gesetzt werden, wodurch eine besonders einfache Herstellung ermöglicht wird.

Es sei erwähnt, dass das Art. 54(3)-Dokument EP 1 715 368 A ein Bauteil zur optischen Kopplung offenbart, bei dem im Koppelelement mit Spiegelflächen und mit Positionsmarken vorliegt; eine Wellenleiterstruktur wird in einem Mehrschichtaufbau auf einem Substrat z.B. durch lokales Aushärten des Materials einer Kernschicht mittels UV-Strahlung angebracht.

Für die Umlenkspiegel können vorgefertigte Silizium-Blöcke eingesetzt werden, die z.B. mit einer ebenen 45°-Schrägfläche versehen wurden, um so eine Licht-Umlenkung um 90° zu erzielen. Außer Silizium-Material kann auch Glas, ein Thermoplast oder ein Duroplast, oder aber ein anorganisch/organisches Hybridpolymer für die Umlenkspiegel verwendet werden, wobei eine Verspiegelung durch Metallbeschichtung vorgesehen werden kann. Insbesondere weist der Umlenkspiegel einen prismatischen Körper mit einer ebenen oder konkaven, nämlich (a)sphärischen Spiegelfläche auf, wobei dann, wenn die Spiegelfläche leicht konkav ausgebildet ist, durch die Hohlspiegelform eine Fokussierungswirkung für den Lichtstrahl erzielt werden kann.

Weiters ist es auch günstig, wenn wie vorstehend bereits angedeutet, ein weiterer Licht-Wellenleiter mit dem Umlenkspiegel optisch gekoppelt wird, um sowohl einen auf ihn auftreffenden als auch einen von ihm reflektierten Lichtstrahl in einem Licht-Wellenleiter zu führen, d.h. der Lichtstrahl wird sowohl im strukturierten Licht-Wellenleiter parallel zur Ebene des Leiterplattenelements geführt als auch senkrecht dazu, um so etwaige Lichtverluste beim eigentlichen Ein- bzw. Auskoppeln hintanzuhalten. Der Licht-Wellenleiter kann im Übrigen auch so strukturiert werden, dass er nicht ganz bis zum Umlenkspiegel geführt wird, sondern in einem - geringen - Abstand davor endet. Dies ist vor allem dann möglich, wenn für die Umlenkung des Lichts zur Oberfläche des Leiterplattenelements auf eine Wellenleiter-Strecke verzichtet werden kann. Durch die vorliegende Strukturierung des Licht-Wellenleiters mittels eines Photonen-Prozesses ist es aber problemlos möglich, den Licht-Wellenleiter bei der Strukturierung exakt bis zum Umlenkspiegel heranzuführen. Weiters ermöglicht diese Strukturierung mittels eines Photonen-Prozesses auch, im Fall des zusätzlichen, vertikalen Licht-Wellenleiters, der zur Oberseite der optischen Schicht führt, an dieser Oberseite, im Bereich des Endes des Licht-Wellenleiters, eine Fokussierungs-Linse im optischen Material zu strukturieren, um so eine zusätzliche Fokussierung des Lichtstrahls nach seiner Reflexion am Umlenkspiegel zu erzielen. Anstatt mittels dieser Photonen-Strukturierung kann jedoch eine solche Fokussierungslinse im Austrittsbereich des vertikal nach oben führenden Licht-Wellenleiters auch dadurch erzeugt werden, dass Material an der Oberfläche des optischen Materials, beispielsweise durch Laserablation, entfernt wird, so dass eine Linse im optischen Material "eingebrannt" wird. Eine weitere Möglichkeit besteht darin, die Linse in einem Abform- oder Stempelprozess zu erzeugen, da das optische Material während des Photonen-Strukturierungsprozesses noch weich und formbar ist.

Der Umlenkspiegel kann anstatt durch Säge- oder Schleifbearbeitungen aus Silizium, Glas oder Duroplasten (z.B. Polyester, ausgehärtete Epoxidharze, Formaldehydharze) wie erwähnt auch aus für einen Abformprozess geeigneten Materialien hergestellt werden, wobei z.B. UV-aushärtende Materialien, wie etwa anorganisch-organische Hybridpolymere, oder aber thermoplastische Materialien, wie z.B. Polykarbonat, Polymethylmethacrylat oder Polystyrol, verwendet werden können. Dabei ist es insbesondere auch denkbar, eine Vielzahl von Umlenkspiegeln auf einem Träger, wie beispielsweise auf einem Siliziumwafer, auf Glas, oder auf einem Träger aus einem Polymer, z.B. Polyimid, gleichzeitig zu erzeugen, etwa nach dem Abformverfahren, wie es aus der EP 1 460 738 A grundsätzlich, allerdings im Zusammenhang mit der Herstellung von Halbleiterbauelementen, bekannt ist. Dies ist eine einfache und kostengünstige Möglichkeit, eine Vielzahl von Spiegeln mit planaren, gegebenenfalls aber auch sphärischen oder asphärischen Spiegelflächen herzustellen, und die verbleibenden Siliziumwafer der einzelnen Umlenkspiegel erleichtert die Handhabung und die Bestückung der Bauteile.

Insgesamt ergibt sich somit, dass mit der vorliegenden Technik ein äußerst kostengünstig herstellbares Leiterplattenelement ermöglicht wird, bei dem als besonders wesentlich der Vorteil einer simultanen Bestückung der Bauteile, nämlich der Umlenkspiegel gleichzeitig mit den anderen, z.B. den optischen aktiven Elementen, wie Laserbauelementen und Photodioden etc., anzusehen ist. Eine präzise Positionierung der Bauelemente ist dabei nicht notwendig, vielmehr können die Bauelemente mit einer handelsüblichen SMT-Einrichtung angebracht werden. Das Strukturieren der Wellenleiter erfolgt dann in einem nachfolgenden Schritt, wobei das Ankoppeln der Licht-Wellenleiter an die Bauelemente mit einer äußerst hohen Präzision erfolgen kann, und zwar anhand der messbaren Position der Bauelemente, die zuvor angebracht wurden, wobei automatisch bei Abweichungen, wie etwa Winkellagen- oder Höhenabweichungen, eine Kompensation bei der Strukturierung der Wellenleiter vorgenommen werden kann.

Mit erfindungsgemäßen Leiterplattenelementen werden Multimode- oder Singlemode-Datenübertragungen mit außerordentlich hohen Datentransferraten ermöglicht, und die Erfindung kann mit Vorteil bei Leiterplatten, z.B. optoelektrischen Backplanes oder Flex-Leiterplatten, für Mobiltelefone und andere so genannte Handhelds, verwendet werden.

Die Erfindung wird nachfolgend anhand von besonders bevorzugten Ausführungsbeispielen, auf die sie jedoch nicht beschränkt sein soll, und unter Bezugnahme auf die Zeichnung noch weiter erläutert. In der Zeichnung zeigen im Einzelnen:
Fig. 1 schematisch eine Schnittansicht eines erfindungsgemäßen Leiterplattenelements mit einem optoelektronischen Bauelement und einem in Abstand davon auf dem selben Substrat angebrachten Umlenkspiegel;
die Fig. 2, 3 und 4 aufeinanderfolgende Herstellungsstufen bei der Herstellung eines derartigen Leiterplattenelements gemäß Fig. 1;
Fig. 5 in einer schematischen Schnittansicht ähnlich Fig. 1 eine modifizierte Ausführungsform eines Leiterplattenelements, bei dem eine weitere Wellenleiter-Strecke an den Umlenkspiegel anschließt;
die Fig. 6, 7 und 8 ein Ausführungsbeispiel für einen vorgefertigten Umlenkspiegel, z.B. aus Silizium oder Glas, in Ansicht, Aufsicht und Seitenansicht;
die Fig. 9 und 10 in Darstellungen ähnlich der Schnittansicht von Fig. 1 ausschnittsweise zwei Leiterplattenelemente, die mit Fokussier-Linsen am Austrittsende eines weiteren, vertikalen
Licht-Wellenleiters ausgebildet sind; und
die Fig. 11 und 12 zwei Beispiele für einen vorgefertigten, nämlich durch einen Abformprozess auf einem Substrat bzw. Träger hergestellten Umlenkspiegel.

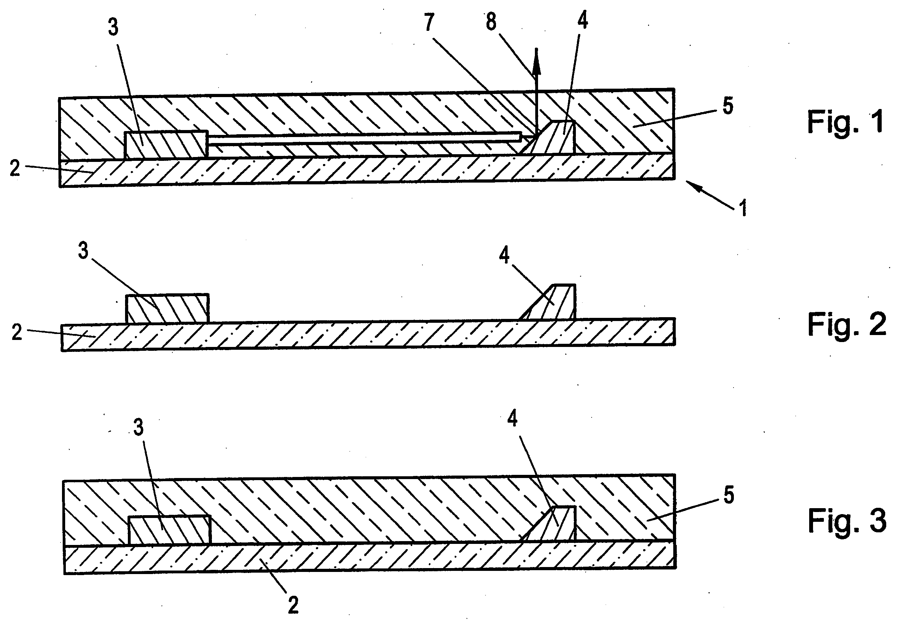

In Fig. 1 ist schematisch ein Leiterplattenelement 1 mit einem Substrat 2, z.B. einem üblichen FR4-Substrat, gezeigt. Auf diesem Substrat 2 sind verschiedene Bauelemente in einem Arbeitsgang angebracht, wobei beispielhaft in Fig. 1 ein optoelektronisches Bauelement 3, etwa eine Laserdiode, und ein passives Bauelement in Form eines Umlenkspiegels 4 gezeigt sind. Diese Bauelemente 3, 4 (sowie andere, in der Zeichnung nicht näher gezeigte Bauelemente) können beispielsweise durch Ankleben auf dem Substrat 2 befestigt werden. Es sei hier erwähnt, dass in Fig. 1 wie auch in den nachfolgenden Zeichnungen die zur Kontaktierung der Bauelemente, z.B. 3 und 4, erforderlichen Leiterbahnen, wie Kupfer-Kaschierungen nach Strukturierung und/oder Kontaktbohrungen etc., nicht näher gezeigt sind. Diesbezüglich kann beispielsweise auf die WO 2005/064381 A1 verwiesen werden.

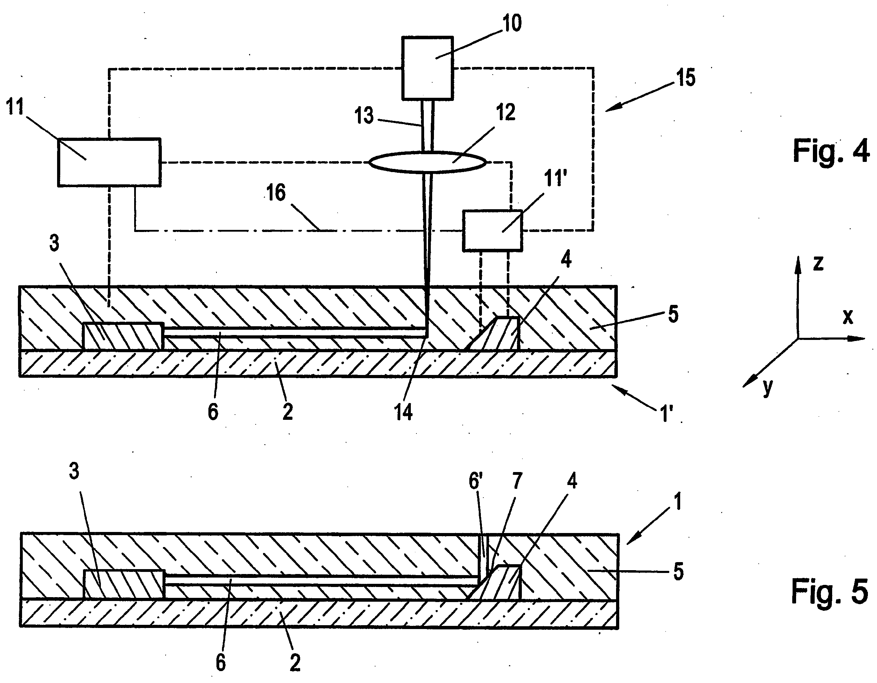

Die Bauelemente 3, 4 sind im Ausführungsbeispiel gemäß Fig. 1 in einem einheitlichen schichtförmigen optischen, photopölymerisierbaren Material 5 eingebettet, in welchem weiters durch einen Zwei- oder Mehr-Photonen-Absorptionsprozess ein Licht-Wellenleiter 6 strukturiert ist. Dieser Licht-Wellenleiter 6 erstreckt sich vom optoelektronischen Bauelement 3 beispielsweise bis knapp vor die 45°-Spiegelfläche 7 des Umlenkspiegels 4. Selbstverständlich ist es aber auch möglich und vielfach bevorzugt, den Licht-Wellenleiter 6 bis direkt an die Spiegelfläche 7 heranzuführen, wie dies auch beim Ausführungsbeispiel gemäß Fig. 5 der Fall ist. Ein derartiger geringer Abstand zwischen dem Ende des Wellenleiters 6 und der Spiegelfläche 7 des Umlenkspiegels 4, wie gemäß Fig. 1, ist dann unproblematisch, wenn das Licht vom Umlenkspiegel 4 einfach zur Oberseite hin (vgl. den Pfeil 8) durch das - dünne - optische Material 5 umgelenkt werden kann. Im Gegensatz dazu ist beim Ausführungsbeispiel gemäß Fig. 5 eine weitere Wellenleiter-Strecke 6' zum Auskoppeln oder aber zum Einkoppeln von Licht vorgesehen, wie nachstehend noch näher erläutert werden wird.

Bei der Herstellung eines Leiterplattenelements 1 gemäß Fig. 1 wird derart vorgegangen, dass ein entsprechendes Substrat 2, wie ein Epoxidharz-Substrat, z.B. das erwähnte FR4-Substrat, in einem Arbeitsgang mit den Bauelementen, also insbesondere mit dem optoelektronischen Bauelement 3 und dem passiven Bauelement in Form des Umlenkspiegels 4, bestückt wird. Die Bauelemente 3, 4 etc. werden auf dem Substrat 2, insbesondere durch Kleben aufgebracht; bei dieser Klebeverbindung können auch elektrische Kontakte im Bereich des optoelektronischen Bauelements 3 vorgesehen werden, was aber hier nicht näher zu erläutern ist. Ein derartiges mit Bauelementen 3, 4 bestücktes Substrat ist in Fig. 2 gezeigt.

Im Anschluss daran wird, vgl. Fig. 3, auf dem Substrat 2 die optische Schicht 5 aus photopolymerisierbarem Material aufgebracht, wobei die zuvor auf dem Substrat 2 angebrachten Bauelemente 3, 4 in diese Schicht 5 eingebettet werden. Das Aufbringen der optischen Schicht 5, die aus einem photoreaktiven Polymer besteht, kann z.B. durch Vergießen, Rakeln oder aber durch Spincoaten, wie an sich bekannt, erfolgen.

Danach wird durch Photonenbestrahlung das optische Material der Schicht 5 lokal derart umgewandelt, dass es örtlich einen vergleichsweise höheren Brechungsindex erhält, um so den gewünschten Licht-Wellenleiter 6 zu strukturieren.

Diese lokale Umwandlung des photoreaktiven, optischen Materials 5 mit Hilfe von Photonenstrahlen ist schematisch in Fig. 4 veranschaulicht. Dabei ist eine Lichtquelle 10, wie etwa eine Laserquelle, ersichtlich, welche mit einer Visionseinheit 11 gekoppelt ist, und welcher ein Linsensystem 12 zur Fokussierung des abgegebenen Laserstrahls 13 in einem Fokusbereich 14 innerhalb des optischen Materials 5 vorgeordnet ist.

Im Einzelnen werden bei dieser Strukturierung des optischen Materials 5 durch die Visions- oder Visiereinheit 11, ausgehend von beispielsweise dem optoelektronischen Bauelement 3, dessen Koordinaten erfasst werden, die Abstände auf der durch das Leiterplattenelement (soweit bereits vorhanden) gegebenen Probe 1' vermessen, und es wird die relative Bewegung zwischen dieser Probe 1' und dem durch die Laserquelle 10 und das Linsensystem 12 gegebenen Belichtungssystem 15 gesteuert, und zwar nicht nur in der Ebene der Probe 1', also in x- bzw. y-Richtung, sondern auch in Dickenrichtung der Probe 1', also in z-Richtung, um so den Fokusbereich 14 des Laserstrahls 13 an der gewünschten Stelle innerhalb des optischen Materials 5 zu erhalten. Bevorzugt wird die Probe 1' in den drei Richtungen x, y und z bewegt, um den Fokusbereich 14 in der gewünschten Weise relativ zur Probe 1' innerhalb von dieser zu bewegen und so durch die Photonenbestrahlung das optische Material 5 lokal umzuwandeln; auf diese Weise wird der strukturierte Licht-Wellenleiter 6 gebildet. Im Fokusbereich 14 ist nämlich die Intensität des Laserlichts so hoch, dass es zu dem bekannten Zwei-Photonen-Absorptionsprozess kommt. Durch diesen Prozess reagiert (polymerisiert) das optische Material 5, so dass der Licht-Wellenleiter 6 gebildet wird, der einen größeren Brechungsindex aufweist, verglichen mit dem ihn umgebenden optischen Material 5. Dadurch wird ein Licht-Wellenleiter 6 ähnlich einem Lichtleiterkabel erhalten, wo im Fall einer Lichtübertragung durch entsprechende Reflexionen des Lichts an der Grenzfläche zwischen dem Licht-Wellenleiter 6 und dem umgebenden Material 5 eine gebündelte Lichtübertragung ohne nennenswerte optische Verluste erzielt wird.

In einem nächsten Schritt kann gegebenenfalls eine obere Leiterplattenschicht (nicht dargestellt) mit einer Epoxidharzschicht und einer Kupfer-Außenlage, insbesondere durch Verpressen, auf dem optischen Material 5 aufgebracht werden, und es können die zur elektrischen Kontaktierung üblichen Schritte gesetzt werden; dies ist an sich herkömmlich und hier nicht weiter zu erläutern.

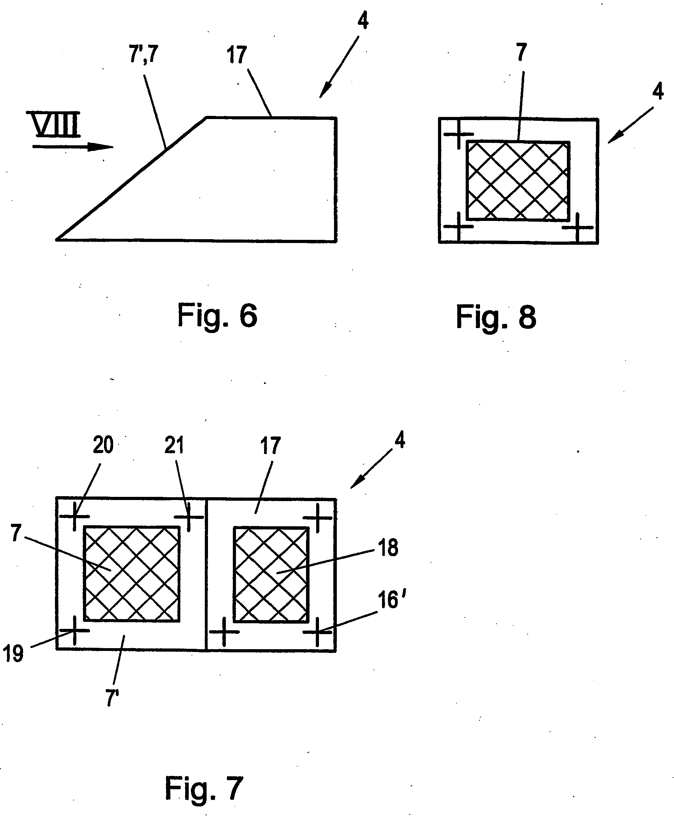

Beim vorliegenden Leiterplattenelement 1 bzw. 1' wird mit einer Visiereinheit 11' die Position des Umlenkspiegels 4 optisch erfasst, wobei der Umlenkspiegel 4 zu diesem Zweck entsprechende Marken trägt, wie nachstehend noch näher anhand der Fig. 6 bis 8 erläutert werden wird. Die Visiereinheit 11' kann ergänzend oder alternativ zur Visiereinheit 11 vorgesehen sein, oder es kann sich um die selbe - verschobene -

Visiereinheit handeln; insbesondere ist es auch möglich, eine zweigeteilte Visiereinrichtung mit einer einheitlichen Rechnereinrichtung, etwa im Bereich der Haupt-Visiereinheit 11, vorzusehen, so dass dann die ergänzende Visiereinheit 11' eine entsprechende, mit strichpunktierter Linie eingezeichnete Verbindung 16 zu dieser Haupt-Visiereinheit 11 aufweist. Andererseits ist es aber auch denkbar, die Visiereinheit 11' allein vorzusehen, wobei dann die mit strichlierten Linien veranschaulichten Ansteuerungen der Laserquelle 10 und der Optik 12 vorgesehen sind.

Von besonderem Vorteil ist bei der vorstehend beschriebenen Technik, dass die Ausrichtung des jeweiligen Licht-Wellenleiters 6 in situ angepasst werden kann, wenn entsprechende ReferenzMarken (s. Fig. 6 bis 8) auf dem Umlenkspiegel oder allgemein auf den Bauelementen für die Lokalisierung der Ein- bzw. Auskoppelstelle in drei Dimensionen angebracht werden.

In Fig. 5 ist ein Leiterplattenelement 1 gezeigt, das im Wesentlichen ähnlich wie jenes gemäß Fig. 1 aufgebaut ist, sich jedoch von diesem dadurch unterscheidet, dass der zur Ebene des Leiterplattenelements 1 parallele Licht-Wellenleiter 6 bis direkt an die Spiegelfläche 7 des Umlenkspiegels 4 herangeführt ist, wobei dann von dieser Spiegelfläche 7 vertikal nach oben, zur Oberseite des Leiterplattenelements 1A, eine weitere Wellenleiter-Strecke 6' strukturiert wurde. Dies ist beim vorliegenden Leiterplattenelement 1 problemlos möglich, und erübrigt nachträgliche mechanische Nachbearbeitungen, da jeder Wellenleiter 6 bzw. 6' durch die Photonen-Strukturierung hochpräzise direkt an die optischen Bauelemente 4 (und auch 3) positioniert werden kann, und da durch die Photonen-Strukturierung auch ein Strukturieren in der z-Richtung (s. Fig. 4) ohne weiteres möglich ist. Auf diese Weise wird bei der Ausführungsform gemäß Fig. 5 eine Umlenkung des Lichts aus der Ebene der optischen Lage (bzw. in die Ebene der optischen Lage) ermöglicht.

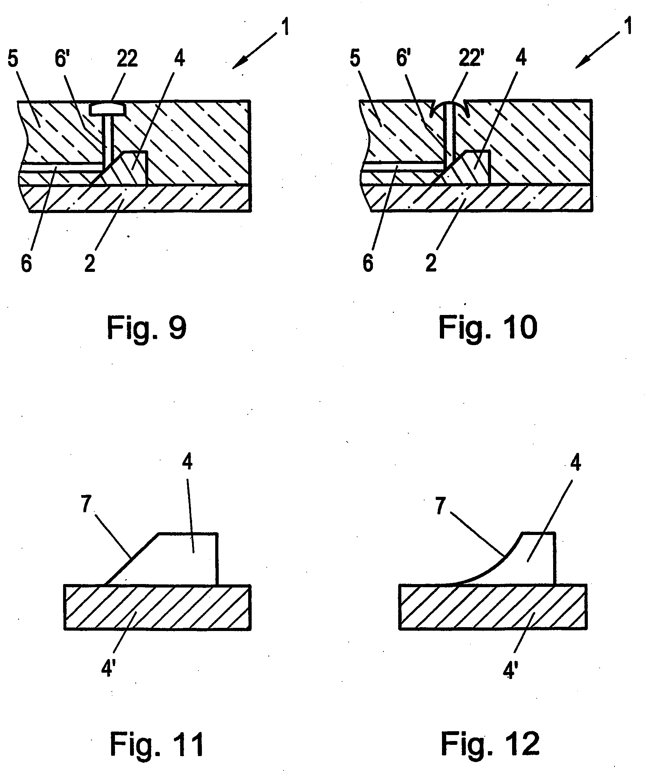

Der Umlenkspiegel 4 kann beispielsweise aus Silizium oder aus Glas mit Metallbeschichtung vorgefertigt sein, und er besteht wie aus der Zeichnung, insbesondere auch aus Fig. 6 bis 8 ersichtlich, bevorzugt aus einem prismatischen Körper mit einer z.B. abgeschrägten (s. Fig. 6 und 9 bis 11) oder konkaven (s. Fig. 12) Vorderfläche 7', zur Bildung der Spiegelfläche 7 oder des Reflexionsfeldes für das Licht im Wellenleiter 6 (s. Fig. 1 oder 5). Im gezeigten Ausführungsbeispiel handelt es sich um einen 45°-Umlenkspiegel 4, so dass wie auch aus Fig. 1 und 5 ersichtlich der Lichtstrahl um insgesamt 90° aus der Ebene des Leiterplattenelements 1 in eine Richtung senkrecht dazu (bzw. umgekehrt) umgelenkt wird. Der vorgefertigte Umlenkspiegel 4 kann nun verschiedene Marken für die Positionierung des Laserstrahls 13 bzw. Fokuspunktes 14 während der Strukturierung des Licht-Wellenleiters 6 bzw. 6' aufweisen. So sind beispielsweise gemäß Fig. 7 Marken 16' an der planen Oberseite 17 des Umlenkspiegels 4 vorgesehen, um die Position bzw. eventuelle Verdrehung des Umlenkspiegels 4 über die Visiereinheit 11' (s. Fig. 4) zu bestimmen. Weiters ist an der Oberseite 17 des Umlenkspiegels 4 als Marke ein reflektives Feld 18 zur Bestimmung der z-Position des Umlenkspiegels 4 über die Reflexion des Vermessungslasers in der Visiereinheit 11' vorgesehen.

Auch ist es möglich, an der Vorderfläche 7', im Bereich der Spiegelfläche 7, Positions-Marken 19, 20 und 21 anzubringen, um so die Lage der Vorderfläche des Umlenkspiegels 4 über die Visiereinheit 11' bestimmen zu können. Die Position-Marken 19, 20 und 21 sind vor allem dafür vorgesehen, Abweichungen der Schräge (im Falle einer ebenen Spiegelfläche 7) oder der gewölbten Fläche (im Fall eines sphärischen oder asphärischen Spiegels 7) von der Solllage zu erkennen, wobei derartige Abweichungen beispielsweise durch Produktionsungenauigkeiten oder aber Bestückungsungenauigkeiten auftreten können. Auf diese Abweichungen kann dann beim Abtasten der Positions-Marken 19, 20, 21 entsprechend reagiert werden, indem der Auftreffwinkel des Licht-Wellenleiters 6 bzw. 6' auf die Spiegelfläche 7 so angepasst wird, dass der durch den strukturierten Licht-Wellenleiter 6 bzw 6' geführte Lichtstrahl optimal vom Umlenkspiegel 4 nach oben oder aber zum optoelektronischen Bauelement 3 hin reflektiert wird.

Ein Vorteil der vorliegenden Technologie liegt darin, dass der Umlenkspiegel 4 gleichzeitig mit den optisch aktiven Bauelementen 3 auf dem Leiterplattensubstrat 2 angebracht werden kann. Von Vorteil ist auch die Verwendung des Photonen-Verfahrens zur Strukturierung des Wellenleiters 6 bzw. 6' im optischen, photopolymerisierbaren Material 5, in dem die Bauelemente 3, 4 eingebettet sind, wobei insbesondere mit der Visiereinheit 11 bzw. 11' sowohl die Position des Umlenkspiegels 4 an sich als auch eine etwaige Verdrehung oder Verkippung, wie dies beim automatischen Bestückungsprozess auftreten kann, erfasst werden kann; dadurch wird bei der Strukturierung des Licht-Wellenleiters 6 bzw. 6' eine entsprechende Anpassung und exakte Ausrichtung ermöglicht, so dass davor eine sehr hohe Genauigkeit beim Bestückungsprozess nicht erforderlich ist. Auch kann mittels des Vermessungslaserstrahls der Visiereinheit 11 bzw. 11' die z-Position des Umlenkspiegels 4 die Position der Oberkante des Umlenkspiegels 4 bezogen auf die Substratoberfläche oder aber bezogen auf die Oberfläche der optischen Schicht 5 genau bestimmt werden. Mit den so ermittelten Positionsdaten in x-, y-, z-Richtung einschließlich einer etwaigen Verdrehung des Umlenkspiegels 4 kann dann der Licht-Wellenleiter 6 sowohl im passenden Winkel als auch in der richtigen Höhe innerhalb der optischen Schicht 5 zum Umlenkspiegel 4 hin eingeschrieben werden, s. Fig. 4, wobei es aber selbstverständlich auch möglich ist, den Licht-Wellenleiter 6 vom Umlenkspiegel 4 weg in Richtung zum optoelektronischen Bauelement 3 einzuschreiben. Weiters ist es wie in Fig. 5 gezeigt möglich, die vertikale Wellenleiter-Strecke 6' senkrecht nach oben zur Oberseite der optischen Schicht 5 einzuschreiben, um so eine optimale Einkopplung oder Auskopplung des Lichts zu erzielen.

Beim Strukturieren des oder der Lichtwellenleiter 6 bzw. 6' kann auch eine optische Linse, insbesondere eine Fokussier-Linse 22, in der optischen Schicht 5 eingeschrieben werden, siehe Fig. 9, um so den durch den Umlenkspiegel 4 nach oben reflektierten Lichtstrahl, der im zusätzlichen Licht-Wellenleiter 6' geführt wird, zu fokussieren. Wie weiters aus Fig. 10 ersichtlich ist, ist es aber auch denkbar, eine derartige Linse 22' zum Fokussieren des austretenden Lichtstrahls auch auf andere Weise herzustellen, z.B. durch Abtragen (beispielsweise durch Laserablation) des optischen Materials der Schicht 5, in der Art eines Einbrennens der Linse 22', oder aber durch einen Abform- oder Stempelprozess, wobei zu berücksichtigen ist, dass das optische Material der Schicht 5 während des Photonen-Strukturierungsprozesses noch weich und somit formbar ist.

Vorstehend wurde für die Vorfertigung der Umlenkspiegel 4 beispielsweise Silizium und Glas, mit Metallbeschichtung, als Material erwähnt. Denkbar sind auch Duroplaste, wie z.B. Polyester, ausgehärtete Epoxidharze oder Formaldehydharze, mit Metallbeschichtung; aus diesen Materialien werden die Umlenkspiegel 4 beispielsweise durch einen Säge- oder Schleifprozess hergestellt. Es ist jedoch auch möglich, die Umlenkspiegel in einem Abformprozess zu erzeugen; dabei können formbare Materialien, wie etwa UV-aushärtende Materialien, z.B. anorganisch-organische Hybridpolymere, verwendet werden, welche nach dem Abformen mit UV-Licht ausgehärtet werden; möglich sind aber auch thermoplastische Materialien, wie etwa Polykarbonat, Polymethylmethacrylat oder Polystyrol, die im weichen Zustand entsprechend zu den Spiegeln geformt und danach unter Abkühlen ausgehärtet werden.

Beispielsweise können Umlenkspiegel auf einem Siliziumträger (Wafer) in einer darauf aufgebrachten Schicht abgeformt werden, und nach dem Aushärten werden die einzelnen Umlenkspiegel samt Siliziumträger ausgeschnitten, wie dies im Prinzip aus dem Bereich der Herstellung von Halbleiterbauelementen bekannt ist. Die Fig. 11 und 12 zeigen zwei derartige Umlenkspiegel 4 mit Siliziumträger 4', wobei im Einzelnen Fig. 11 einen Umlenkspiegel 4 auf einem Substrat oder Träger 4' mit einer planen Spiegelfläche 7 zeigt; Fig. 12 zeigt dagegen einen auf einem Substrat 4' geformten Umlenkspiegel 4 mit einer konkaven (einer sphärischen oder aber asphärischen) Spiegelfläche 7.

Anders als bei den bekannten Techniken ist es bei der Erfindung nicht nötig, während des Herstellungsprozesses oder nach dem Herstellungsprozess den Licht-Wellenleiter 6 bzw. 6' mechanisch zu unterbrechen oder in irgendeiner Form nachzubehandeln. Auch wird der Umlenkspiegel 4 nicht nachträglich eingesetzt, was mit zusätzlichem Aufwand verbunden wäre, und er muss auch nicht zum Licht-Wellenleiter 6 ausgerichtet werden. Durch die Vermessung mittels der Visiereinheit 11 bzw. 11' kann jede Positions-Abweichung des Umlenkspiegels 4, etwa aufgrund von Bestückungs-Ungenauigkeiten, Unebenheiten des Substrats 2, usw., jedes einzelnen Umlenkspiegels 4 erfasst werden, wodurch der Licht-Wellenleiter 6 bzw. 6' optimal relativ zum Umlenkspiegel 4 positioniert werden kann.

Dadurch, dass der Umlenkspiegel 4 auf dem selben Substrat 2 wie das optoelektronische Bauelement 3 angebracht ist, ist es in vorteilhafter Weise möglich, die Bauelemente 3, 4 (und andere Bauelemente) im selben Bestückungsvorgang aufzubringen, was nicht nur eine Zeit- und Kostenersparnis, sondern auch eine höhere Bestückungsgenauigkeit mit sich bringt.

## Patentansprüche

1. Leiterplattenelement (1) mit einem Substrat (2), mit wenigstens einem optoelektronischen Bauelement (3, 4), das in einem in schichförmigen vorliegenden photopolymerisierbaren optischen Material (5) eingebettet ist, und mit wenigstens einem damit optisch gekoppelten Licht-Wellenleiter (6), der in dem optischen Material (5) durch Zwei- oder Mehrphotonen-Absorption strukturiert ist, **dadurch gekennzeichnet, dass** auf dem Substrat (2) ein vorgefertigter Umlenkspiegel (4) befestigt ist, der im optischen Material (5) eingebettet ist, und der über den Licht-Wellenleiter (6) mit dem optoelektronischen Bauelement (3) optisch gekoppelt ist, und dass der Umlenkspiegel (4) Positions-Marken (16', 18, 19-21) für die Steuerung eines Laserstrahls (13) bei der Strukturierung des Licht-Wellenleiters (6, 6') aufweist, wobei der Umlenkspiegel (4) und/oder ein Träger (4') desselben, mit dem zusammen der Umlenkspiegel auf dem Substrat (2) angeordnet ist, ein nach oben gewandtes zusätzliches reflektives Feld (18) zur Bestimmung der Höhenlage bei der Strukturierung aufweist.

2. Leiterplattenelement nach Anspruch 1, **dadurch gekennzeichnet, dass** die Positions-Marken (16', 18, 19-21) auf dem Träger (4') des Umlenkspiegels (4) angeordnet sind.

3. Leiterplattenelement nach Anspruch 1 oder 2, **dadurch gekennzeichnet, dass** der Umlenkspiegel (4) im Bereich seiner Spiegelfläche (7) Markierungen (19, 20, 21) zwecks Feststellen von Abweichungen der Spiegelfläche (7) von der Soll-Position und Steuern des Laserstrahls (13) bei der Strukturierung des Licht-Wellenleiters (6, 6') aufweist, um ein optimales Führen eines Lichtstrahls im Licht-Wellenleiter (6, 6') vor bzw. nach dem Umlenkspiegel (4) sicherzustellen.

4. Leiterplattenelement nach einem der Ansprüche 1 bis 3, **dadurch gekennzeichnet, dass** der Umlenkspiegel (4) auf demselben Substrat (2), das auch das optoelektronische Bauelement (3) trägt, aufgebracht ist.

5. Leiterplattenelement nach einem der Ansprüche 1 bis 4, **dadurch gekennzeichnet, dass** der Umlenkspiegel (4) auf dem Substrat (2) aufgeklebt ist.

6. Leiterplattenelement nach einem der Ansprüche 1 bis 5, **dadurch gekennzeichnet, dass** der Umlenkspiegel (4) aus Siliziummaterial, aus einem Thermoplast, aus einem Duroplast, aus Glas, oder aus einem anorganisch/organischen Hybridpolymer, mit Metallbeschichtung, besteht.

7. Leiterplattenelement nach einem der Ansprüche 1 bis 6, **dadurch gekennzeichnet, dass** der Umlenkspiegel (4) einen prismatischen Körper mit ebener Spiegelfläche (7) aufweist.

8. Leiterplattenelement nach einem der Ansprüche 1 bis 6, **dadurch gekennzeichnet, dass** der Umlenkspiegel (4) eine konkave Spiegelfläche (7) aufweist.

9. Leiterplattenelement nach einem der Ansprüche 1 bis 8, **dadurch gekennzeichnet, dass** mit dem Umlenkspiegel (4) ein weiterer Licht-Wellenleiter (6') optisch gekoppelt ist, um sowohl einen auf ihn auftreffenden als auch einen von ihm reflektierten Lichtstrahl in einem Licht-Wellenleiter (6, 6') zu führen.

10. Leiterplattenelement nach Anspruch 9, **dadurch gekennzeichnet, dass** dem weiteren Licht-Wellenleiter (6') im Bereich der Oberfläche des optischen Materials (5) eine Fokussierungs-Linse (22) zugeordnet ist.

11. Leiterplattenelement nach Anspruch 10, **dadurch gekennzeichnet, dass** die Linse (22) im optischen Material (5) durch Photonen-Absorptions-Strukturierung erzeugt ist.

12. Leiterplattenelement nach Anspruch 10, **dadurch gekennzeichnet, dass** die Linse (22') im optischen Material (5) durch Laserablation erzeugt ist.

13. Leiterplattenelement nach Anspruch 10, **dadurch gekennzeichnet, dass** die Linse (22') im optischen Material (5) durch einen Abform- oder Stempelprozess erzeugt ist.

14. Leiterplattenelement nach einem der Ansprüche 1 bis 13, **dadurch gekennzeichnet, dass** der bzw. zumindest einer der Licht-Wellenleiter (6) in einem Abstand vor dem Umlenkspiegel (4) endet.

15. Leiterplattenelement nach einem der Ansprüche 1 bis 14, **dadurch gekennzeichnet, dass** der bzw. zumindest einer der Licht-Wellenleiter (6, 6'), vorzugsweise beide Licht-Wellenleiter, bis zum Umlenkspiegel (4) geführt ist.

16. Verfahren zum Herstellen eines Leiterplattenelements (1) nach einem der Ansprüche 1 bis 17, **dadurch gekennzeichnet, dass** der Umlenkspiegel (4) auf dem Substrat (2) befestigt und danach das photopolymerisierbare optische Material (5) schichtförmig aufgebracht wird, wobei der Umlenkspiegel (4) im optischen Material (5) eingebettet wird, und dass dann der Licht-Wellenleiter (6) durch Richten eines Laserstrahls (13) auf die gewünschte Stelle im optischen Material (5) und durch relatives Bewegen von Laserstrahl (13) und Substrat (2) samt optischem Material (5) mittels Zwei- oder Mehrphotonen-Absorption strukturiert wird, wobei die Fokussierung und/oder Relativbewegung des Strukturierungs-Laserstrahls (13) mit Hilfe von Positions-Marken (16', 18, 19-21) am Umlenkspiegel (4) gesteuert wird, wobei der Umlenkspiegel (4) und/oder ein Träger (4') desselben, mit dem zusammen der Umlenkspiegel auf dem Substrat (2) angeordnet ist, ein nach oben gewandtes zusätzliches reflektives Feld (18) zur Bestimmung der Höhenlage bei der Strukturierung aufweist.

17. Verfahren nach Anspruch 16, **dadurch gekennzeichnet, dass** der Umlenkspiegel (4) oder Träger (4') auf dem Substrat (2) aufgeklebt wird.

18. Verfahren nach Anspruch 16 oder 17, **dadurch gekennzeichnet, dass** mit Hilfe der Positions-Marken Abweichungen (19-21) der Spiegelfläche (7) von der Soll-Position erfasst und davon abhängig der Strukturierungs-Laserstrahl (13) zur Strukturierung des Licht-Wellenleiters (6) für eine optimale Führung des Lichtstrahls (13) gesteuert wird.

19. Verfahren nach einem der Ansprüche 16 bis 18, **dadurch gekennzeichnet, dass** die Strukturierung des Licht-Wellenleiters (6) in Abstand vor dem Umlenkspiegel (4) gestoppt wird.

20. Verfahren nach einem der Ansprüche 16 bis 19, **dadurch gekennzeichnet, dass** der Licht-Wellenleiter (6) beim Strukturieren bis direkt an den Umlenkspiegel (4) herangeführt wird.

21. Verfahren nach einem der Ansprüche 16 bis 20, **dadurch gekennzeichnet, dass** zwei Licht-Wellenleiter (6, 6'), einer für einen auf dem Umlenkspiegel (4) auftreffenden Lichtstrahl und einer für den von ihm reflektierten Lichtstrahl, im schichtförmigen optischen Material (5) strukturiert werden.

22. Verfahren nach Anspruch 21, **dadurch gekennzeichnet, dass** im Bereich des Endes des einen Licht-Wellenleiters (6') an der Oberfläche des optischen Materials eine Fokussier-Linse (22, 22') im optischen Material erzeugt wird.

23. Verfahren nach Anspruch 22, **dadurch gekennzeichnet, dass** die Linse (22) beim Strukturieren mittels Photonen-Absorption mit Hilfe des Laserstrahls erzeugt wird.

24. Verfahren nach Anspruch 22, **dadurch gekennzeichnet, dass** die Linse (22') durch Laserablation erzeugt wird.

25. Verfahren nach Anspruch 22, **dadurch gekennzeichnet, dass** die Linse (22') durch einen Abform- oder Stempelprozess erzeugt wird.

26. Verfahren nach einem der Ansprüche 16 bis 25, **dadurch gekennzeichnet, dass** der Umlenkspiegel (4) durch Abformung und Härten eines formbaren Materials, z.B. eines anorganisch-organischen Hybridpolymers oder eines thermoplastischen Materials auf einem Träger (4'), z.B. aus Silizium, Glas, Polymer, wie Polyimid oder Polycarbonat, hergestellt wird.

## Claims

1. A printed circuit board element (1) with a substrate (2), with at least one optoelectronic component (3, 4) embedded in a photopolymerizable optical layer material (5), and with at least one optical waveguide (6) optically coupled with the former and structured in the optical material (5) by two or multi-photon absorption, **characterized in that** a prefabricated deflection mirror (4) embedded in the optical material (5) and optically coupled with the optoelectronic component (3) via the optical waveguide (6) is attached to the substrate (2) and that the deflection mirror (4) comprises position marks (16', 18, 19-21) for controlling a laser beam (13) during the structuring of the optical waveguide (6, 6'), wherein the deflection mirror (4) and/or a support (4') thereof along with which the deflection mirror is arranged on the substrate (2) comprises an upwardly facing additional reflective field (18) for determining the height position during structuring.

2. The printed circuit board element according to claim 1, **characterized in that** the position marks (16', 18, 19-21) are arranged on the support (4') of the deflection mirror (4).

3. The printed circuit board element according to claim 1 or 2, **characterized in that** the deflection mirror (4), in the region of its mirror surface (7), comprises marks (19, 20, 21) for determining deviations of the mirror surface (7) from the desired position and for controlling the laser beam (13) during the structuring of the optical waveguide (6, 6') in order to ensure the optimum guidance of a light beam in the optical waveguide (6, 6') in front of and/or behind the deflection mirror (4).

4. The printed circuit board element according to any one of claims 1 to 3, **characterized in that** the deflection mirror (4) is applied on the same substrate (2) which carries the optoelectronic component (3).

5. The printed circuit board element according to any one of claims 1 to 4, **characterized in that** the deflection mirror (4) is glued to the substrate (2).

6. The printed circuit board element according to any one of claims 1 to 5, **characterized in that** the deflection mirror (4) is made of a silicon material, a thermoplast, a duroplast, glass or an inorganic/organic hybrid polymer, including a metal coating.

7. The printed circuit board element according to any one of claims 1 to 6, **characterized in that** the deflection mirror (4) comprises a prismatic body having a plane mirror surface (7).

8. The printed circuit board element according to any one of claims 1 to 6, **characterized in that** the deflection mirror (4) comprises a concave mirror surface (7).

9. The printed circuit board element according to any one of claims 1 to 8, **characterized in that** a further optical waveguide (6') is optically coupled with the deflection mirror (4) to guide within an optical waveguide (6, 6') both a light beam impinging on it and a light beam reflected by it.

10. The printed circuit board element according to claim 9, **characterized in that** a focussing lens (22) is associated with said further optical waveguide (6') in the region of the surface of the optical material (5).

11. The printed circuit board element according to claim 10, **characterized in that** the lens (22) is obtained in the optical material (5) by photon absorption structuring.

12. The printed circuit board element according to claim 10, **characterized in that** the lens (22') is obtained in the optical material (5) by laser ablation.

13. The printed circuit board element according to claim 10, **characterized in that** the lens (22') is obtained in the optical material (5) by a molding or stamping process.

14. The printed circuit board element according to any one of claims 1 to 13, **characterized in that** the or at least one optical waveguide (6) ends at a distance in front of the deflection mirror (4).

15. The printed circuit board element according to any one of claims 1 to 14, **characterized in that** the or at least one optical waveguide (6, 6'), preferably both optical waveguides, are guided as far as to the deflection mirror (4).

16. A method for producing a printed circuit board element (1) according to any one of claims 1 to 15, **characterized in that** the deflection mirror (4) is attached to the substrate (2) and the photopolymerizable optical material (5) is subsequently applied in layer form, whereby the deflection mirror (4) is embedded in said optical material (5), and that the optical waveguide (6) is then structured by two or multi-photon absorption, by directing a laser beam (13) onto the desired site in the optical material (5) and relatively moving said laser beam (13) and said substrate (2) along with said optical material (5), wherein the focussing and/or relative movement of the structuring laser beam (13) is controlled by the aid of position marks (16', 18, 19-21) provided on the deflection mirror (4), wherein the deflection mirror (4) and/or a support (4') thereof along with which the deflection mirror is arranged on the substrate (2) comprises an upwardly facing additional reflective field (18) for determining the height position during structuring.

17. The method according to claim 16, **characterized in that** the deflection mirror (4) or support (4') is glued to the substrate (2).

18. The method according to claims 16 or 17, **characterized in that** deviations (19-21) of the mirror surface (7) from the desired position are detected by the aid of position marks and, as a function thereof, the structuring laser beam (13) used for structuring the optical waveguide (6) is controlled for an optimum guidance of the light beam (13).

19. The method according to any one of claims 16 to 18, **characterized in that** said structuring of the optical waveguide (6) is stopped at a distance in front of the deflection mirror (4).

20. The method according to any one of claims 16 to 19, **characterized in that** the optical waveguide (6) is extended directly as far as the deflection mirror (4) during structuring.

21. The method according to any one of claims 16 to 20, **characterized in that** two optical waveguides (6, 6') are structured in the optical layer material (5), namely one for a light beam impinging on the deflection mirror (4) and one for the light beam reflected by it.

22. The method according to claim 21, **characterized in that** a focussing lens (22, 22') is produced in the optical material in the region of the end of the one of the optical waveguides (6'), on the surface of the optical material.

23. The method according to claim 22, **characterized in that** the lens (22) is produced during structuring by photon absorption using the laser beam.

24. The method according to claim 22, **characterized in that** the lens (22') is produced by laser ablation.

25. The method according to claim 22, **characterized in that** the lens (22') is produced by a molding or stamping process.

26. The method according to any one of claims 16 to 25, **characterized in that** the deflection mirror (4) is produced by molding and curing a moldable material, e.g. an inorganic-organic hybrid polymer or a thermoplastic material, on a support (4') made, e.g., of silicon, glass, polymer like polyimide or polycarbonate.

## Revendications

1. Élément de carte de circuits imprimés (1) comportant un substrat (2), comportant au moins un composant optoélectronique (3, 4), qui est incorporé dans un matériau optique (5) pouvant être photopolymérisé existant sous forme de couches, et comportant au moins un guide d'ondes optiques couplé optiquement à celui-ci (6), qui est structuré dans le matériau optique (5) par absorption à deux ou plusieurs photons, **caractérisé en ce que**, sur le substrat (2) est fixé un miroir de renvoi préfabriqué (4), qui est incorporé dans le matériau optique (5), et qui est couplé optiquement au composant optoélectronique (3) par l'intermédiaire du guide d'ondes optiques (6), et **en ce que** le miroir de renvoi (4) présente des repères de position (16', 18, 19-21) pour la commande d'un rayon laser (13) lors de la structuration du guide d'ondes optiques (6, 6'), dans lequel le miroir de renvoi (4) et/ou un support (4') de celui-ci, avec lequel le miroir de renvoi est disposé conjointement sur le substrat (2), présente un champ réfléchissant supplémentaire orienté vers le haut (18) pour déterminer la hauteur lors de la structuration.

2. Élément de carte de circuits imprimés selon la revendication 1, **caractérisé en ce que** les repères de position (16', 18, 19-21) sont disposés sur le support (4') du miroir de renvoi (4).

3. Élément de carte de circuits imprimés selon la revendication 1 ou 2, **caractérisé en ce que** le miroir de renvoi (4) présente dans la zone de sa surface de miroir (7) des repères (19, 20, 21) pour déterminer des écarts de la surface de miroir (7) par rapport à la position prescrite et commander le rayon laser (13) lors de la structuration du guide d'ondes optiques (6, 6'), afin d'assurer un guidage optimal d'un rayon lumineux dans le guide d'ondes optiques (6, 6') avant ou après le miroir de renvoi (4).

4. Élément de carte de circuits imprimés selon l'une des revendications 1 à 3, **caractérisé en ce que** le miroir de renvoi (4) est disposé sur le même substrat (2), qui supporte également le composant optoélectronique (3).

5. Élément de carte de circuits imprimés selon le l'une des revendications 1 à 4, **caractérisé en ce que** le miroir de renvoi (4) est collé sur le substrat (2).

6. Élément de carte de circuits imprimé selon l'une des revendications 1 à 5, **caractérisé en ce que** le miroir de renvoi (4) est réalisé en un matériau en silicium, en un thermoplaste, en un duroplaste, en verre, ou en un polymère hybride inorganique/organique, avec un revêtement métallique.

7. Élément de carte de circuits imprimés selon l'une des revendications 1 à 6, **caractérisé en ce que** le miroir de renvoi (4) présente un corps prismatique avec une surface de miroir plane (7).

8. Élément de carte de circuits imprimés selon l'une des revendications 1 à 6, **caractérisé en ce que** le miroir de renvoi (4) présente une surface de miroir concave (7).

9. Élément de carte de circuits imprimés selon l'une des revendications 1 à 8, **caractérisé en ce qu'**un autre guide d'ondes optiques (6') est couplé optiquement avec le miroir de renvoi (4), pour guider dans un guide d'ondes optiques (6, 6') non seulement un rayon lumineux le frappant mais également un rayon lumineux réfléchi par lui.

10. Élément de carte de circuits imprimés selon la revendication 9, **caractérisé en ce qu'**une lentille de focalisation (22) est associée à l'autre guide d'ondes optiques (6') dans la zone de la surface du matériau optique (5).

11. Élément de carte de circuits imprimés selon la revendication 10, **caractérisé en ce que** la lentille (22) est générée par structuration par absorption à photons dans le matériau optique (5).

12. Élément de carte de circuits imprimés selon la revendication 10, **caractérisé en ce que** la lentille (22') est générée par ablation laser dans le matériau optique (5).

13. Élément de carte de circuits imprimés selon la revendication 10, **caractérisé en ce que** la lentille (22') est générée par un processus de moulage ou d'estampage dans le matériau optique (5).

14. Élément de carte de circuits imprimés selon l'une des revendications 1 à 13, **caractérisé en ce que** le ou au moins un des guides d'ondes optiques (6) se termine à une distance avant le miroir de renvoi (4).

15. Élément de carte de circuits imprimés selon l'une des revendications 1 à 14, **caractérisé en ce que** le ou au moins un des guides d'ondes optiques (6, 6'), de préférence les deux guides d'ondes optiques, est guidé jusqu'au miroir de renvoi (4).

16. Procédé de fabrication d'un élément de carte de circuits imprimés (1) selon l'une des revendications 1 à 15, **caractérisé en ce que** le miroir de renvoi (4) est fixé sur le substrat (2) et ensuite le matériau optique photopolymérisable (5) est déposé sous forme de couches, dans lequel le miroir de renvoi (4) est incorporé dans le matériau optique (5), et **en ce qu'**ensuite le guide d'ondes optiques (6) est structuré par orientation d'un rayon laser (13) sur l'endroit souhaité dans le matériau optique (5) et par déplacement relatif du rayon laser (13) et du substrat (2) y compris du matériau optique (5) grâce à une absorption à deux ou à plusieurs photons, dans lequel la focalisation et/ou le mouvement relatif du rayon laser de structuration (13) est commandé à l'aide de repères de position (16', 18, 19-21) vers le miroir de renvoi (4), dans lequel le miroir de renvoi (4) et/ou un support (4') de celui-ci, avec lequel le miroir de renvoi est disposé conjointement sur le substrat (2), présente un champ réfléchissant supplémentaire orienté vers le haut (18) pour déterminer la hauteur lors de la structuration.

17. Procédé selon la revendication 16, **caractérisé en ce que** le miroir de renvoi (4) ou le support (4') est collé sur le substrat (2).

18. Procédé selon la revendication 16 ou 17, **caractérisé en ce que** des écarts (19-21) de la surface de miroir (7) par rapport à la position prescrite sont détectés grâce à des repères de position et indépendamment de cela, le rayon laser de structuration (13) est commandé pour structurer le guide d'ondes optiques (6) pour un guidage optimal du rayon lumineux (13).

19. Procédé selon l'une des revendications 16 à 18, **caractérisé en ce que** la structuration du guide d'ondes optiques (6) est stoppée à une distance avant le miroir de renvoi (4).

20. Procédé selon l'une des revendications 16 à 19, **caractérisé en ce que** le guide d'ondes optiques (6) est amené directement sur le miroir de renvoi (4) lors de la structuration.

21. Procédé selon l'une des revendications 16 à 20, **caractérisé en ce que** deux guides d'ondes optiques (6, 6') l'un pour un rayon lumineux frappant le miroir de renvoi (4) et l'un pour le rayon lumineux réfléchi, sont structurés dans le matériau optique qui est sous forme de couches (5).

22. Procédé selon la revendication 21, **caractérisé en ce qu'**une lentille de focalisation (22, 22') est générée dans la zone de l'extrémité d'un guide d'ondes optiques (6') à la surface du matériau optique.

23. Procédé selon la revendication 22, **caractérisé en ce que** la lentille est générée lors de la structuration au moyen d'une absorption photonique à l'aide du rayon laser.

24. Procédé selon la revendication 22, **caractérisé en ce que** la lentille (22') est générée par ablation laser.

25. Procédé selon la revendication 22, **caractérisé en ce que** la lentille (22') est générée par un processus de moulage ou d'estampage.

26. Procédé selon l'une des revendications 16 à 25, **caractérisé en ce que** le miroir de renvoi (4) est réalisé par moulage et durcissement d'un matériau pouvant être moulé, par exemple un polymère hybride inorganique-organique ou d'un matériau thermoplastique sur un support (4'), par exemple en silicium, verre, polymère, comme le polyimide ou le polycarbonate.
